# EUROPEAN PATENT APPLICATION

(11) **EP 4 832 056 A1**
(43) Date of publication of application: **28.10.2026**
(21) Application number: 25172404.3
(22) Date of filing: 24.04.2025
(51) Int. Cl.: H01L 21/683

(54) **A METHOD FOR TRANSFERRING MICROELECTRONIC COMPONENTS FROM A TEMPORARY CARRIER TO A RECEIVING SUBSTRATE**

(71) Applicant: Imec VZW, 3001 Leuven (BE)
(72) Inventor: Phommahaxay, Mr. Alain, 1490 Court Saint Etienne (BE); Bex, Mr. Pieter, 3583 Paal (BE)
(74) Representative: Patent Department IMEC

(57) **Abstract**

Micro-electronic components (1) are transferred from a temporary carrier substrate (2) to a receiving substrate (5). The components are attached to the temporary carrier by a light-sensitive adhesive layer (4), configured to release its adhesive force under the influence of a light source (7) illuminating the components through the back side of the carrier (2), the latter being transparent to the light produced by the source. A programmable screen (6) is positioned between the light source and the temporary carrier substrate. The screen is programmable in the sense that the transparency of areas (10) of the screen (6) which are aligned to individual components (1) on the temporary carrier (2) can be set to a programmed value, including values equivalent to fully transparent and fully non-transparent, as well as values of intermediate transparency. The screen (6) is programmed to enable the transfer of a subgroup of the components (1) attached to the temporary carrier, by illuminating the components of the subgroup, while the components not belonging to the subgroup remain attached to the temporary carrier.

## Description

### Field of the Invention

The present invention is related to the assembly of small micro-electronic components such as micro-electronic dies produced in electronic manufacturing processes.

### State of the art.

Micro-electronic components are produced on a process wafer and in many cases the components are thereafter transferred to a temporary carrier substrate such as a dicing tape or a glass carrier wafer. The components are separated by a singulation technique, after which they need to be transferred to a permanent substrate.

Standard transfer techniques include pick and place methods which are however not suited for the transfer of very large quantities of components (so-called "mass transfer").

Certain types of components are transferred from a temporary carrier by bringing the carrier in close proximity to the permanent substrate and ejecting the components from the temporary carrier towards respective landing sites on the permanent substrate. This technique is used for example for the placement of Red, Blue and Green LEDs on a display substrate. The individual LEDs are very small and the number of LEDs that need to be transferred onto a single display can run into the millions of components.

According to the standard mechanical transfer technique, the LEDs are transferred from a dicing tape to the permanent substrate by a needle pushing the LEDs towards said substrate. As the number of LEDs becomes higher, the speed of this technique is insufficient to enable an acceptable throughput.

Non-mechanical transfer by laser light is another known technique. Here the components are attached to the temporary carrier by a light-sensitive adhesive that releases upon illumination of the adhesive through the backside of a transparent temporary carrier. The use of a laser is however an expensive solution, while this approach does not enable a significant increase of the process speed.

### Summary of the invention

The invention is related to methods in accordance with the appended claims. Micro-electronic components are transferred from a temporary carrier substrate to a receiving substrate. The components are attached to the temporary carrier by a light-sensitive adhesive layer, configured to release its adhesive force under the influence of a light source illuminating the components through the back side of the carrier, the latter being transparent to the light produced by the source. A programmable screen is positioned between the light source and the temporary carrier substrate. The screen is programmable in the sense that the transparency of areas of the screen which are aligned to individual components on the temporary carrier can be set to a programmed value, including values equivalent to fully transparent and fully non-transparent, as well as values of intermediate transparency. The screen is programmed to enable the transfer of a subgroup of the components attached to the temporary carrier, by illuminating the components of the subgroup, while the components not belonging to the subgroup remain attached to the temporary carrier.

Various embodiments according to the invention are enabled by the above configuration, including for example faster methods for transferring large numbers of LEDs onto a display substrate. By setting the transparency of selected areas of the screen to an intermediate value, a pre-release of selected components is possible, which can equally contribute to faster mass transfer of components.

The invention is equally related to an apparatus for performing methods according to embodiments of the invention, and to computer programs for controlling said apparatus.

The invention is in particular related to a method for transferring micro-electronic components from a temporary carrier substrate to a receiving substrate, wherein the components are attached to said temporary carrier substrate by a light-sensitive adhesive layer, wherein the transfer is realized by illuminating the adhesive layer with a light source through the temporary carrier substrate, the latter being transparent to light produced by the light source, and wherein :
- the receiving substrate and the temporary carrier substrate are placed relative to each other so that a subgroup of components is facing respective receiving sites for the components of said subgroup on the receiving substrate,
- a programmable screen is positioned between the light source and the temporary carrier substrate, said screen being programmable in the sense that the transparency of individual areas of the screen which are aligned to respective individual components on the temporary carrier substrate can be set to a programmed transparency,
- the screen is programmed in such a way that the screen is transparent to light from said light source in areas of the screen aligned to the components of the subgroup, the transparency of said areas being sufficient for releasing the components of the subgroup, while the transparency of areas of the screen aligned to components not belonging to the subgroup is insufficient for releasing said components,
- the light source illuminates the temporary carrier substrate through the programmed screen, thereby releasing the components of the subgroup and transferring said components to their respective receiving sites (R), while components not belonging to the subgroup remain attached to the temporary carrier substrate.

According to an embodiment, the release of the components of the subgroup is performed in two or more steps comprising :
- one or more preparatory steps wherein the components of the subgroup are illuminated through the screen and wherein the screen is programmed in such a way that the screen is intermediately transparent to light from said light source in said individual areas of the screen aligned to the components of the subgroup, and wherein the intermediate transparency of said individual areas of the screen is sufficient to reduce the adhesive force of said adhesion layer but not sufficient to fully release the components,
- thereafter, a final step wherein the components of the subgroup are illuminated through the screen and wherein the screen is programmed in such a way that the screen is transparent to light from said light source in said individual areas of the screen aligned to the components of the subgroup, the transparency of said areas being sufficient for releasing the components of the subgroup in a shorter timespan compared to a timespan required for releasing the components without applying the one or more preparatory steps.

According to an embodiment, simultaneously with one or more of said preparatory steps, components of other subgroups are fully released by the illumination of the light source.

According to an embodiment, said method is applied for transferring red, green and blue LEDs from respective temporary carrier substrates onto a receiving substrate according to a given layout and pitch, the method comprising the steps of :
- transferring selected red LEDs to respective receiving sites,
- transferring selected green LEDs to respective receiving sites,
- transferring selected blue LEDs to respective receiving sites,
According to an embodiment, the components of the subgroup are replacement dies transferred to respective replacement sites on the receiving substrate.

According to an embodiment, the programmable screen is an LCD screen.

According to an embodiment, the light source is configured to illuminate simultaneously all the components of said subgroup.

According to an embodiment, the light source is a broadband UV light source.

According to an embodiment, the light source is a laser source configured to produce a laser beam, wherein the laser beam is scanned along a trajectory that includes the areas of the screen aligned to the components of the subgroup.

According to an embodiment, the dimensions of said areas of the screen aligned to the components of the subgroup are adjusted to take into account a divergence of light inside the temporary carrier, and to thereby avoid the release of components not belonging to the subgroup and aligned to neighbouring areas of the screen.

The invention is also related to an apparatus for performing a method according to the invention, the apparatus comprising a light source, a programmable screen, and a holding structure for positioning a receiving substrate and a temporary carrier substrate relative to each other and relative to the programmable screen and the light source.

According to an embodiment, the apparatus comprises or is configured to be coupled to a computer configured for programming the programmable screen.

According to an embodiment, the apparatus comprises or is configured to be coupled to a control unit configured to operate according to instructions for causing the apparatus to perform method steps of said method according to the invention.

The invention is also related to a computer program product comprising instructions for causing the apparatus according to the invention to perform method steps of the method according the invention.

The invention is also related to a computer-readable medium having stored thereon a computer program product according to the invention.

### Brief description of the figures

Figures 1 to 6 illustrate method steps according to an embodiment of the invention related to the transfer of LEDs from a temporary carrier substrate to a receiving substrate.
Figures 7 to 10 illustrate an embodiment wherein groups of dies are pre-released from a temporary carrier substrate, before being fully released.
Figure 11 is a detail of Figure 4, illustrating the possible influence of light propagating to neighbouring dies not intended to be released.
Figure 12 illustrates an embodiment wherein the dimensions of transparent portions of the programmable screen take into account a diverging propagation of light through the temporary carrier substrate.

### Detailed description of the invention

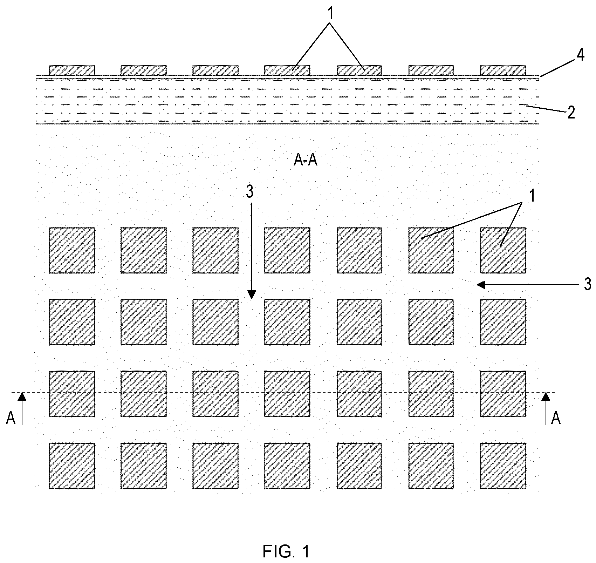

A first example of a method in accordance with the invention is illustrated in Figures 1 to 6. Figure 1 shows a section view and a plane view of a number of identical red LEDs 1 (Light Emitting Diodes) attached to a temporary carrier substrate 2 (which may hereafter be referred to by the abbreviated 'carrier'). The LEDs 1 may be produced in any known way, such as by epitaxial growth on a sapphire process wafer. From the process wafer, the LEDs are transferred by a flip-chip technique to the temporary carrier 2. The LEDs 1 may be singulated either on the process wafer or on the temporary carrier substrate 2, so that on the temporary carrier, the LEDs 1 are individual dies separated by singulation lanes 3 and arranged in a regular rectangular array. The LEDs 1 are attached to the temporary carrier 2 by a light-sensitive adhesive layer 4. In the present description, a light-sensitive adhesive is defined as an adhesive of which the adhesive force is reduced under the influence of light of a given wavelength. The temporary carrier substrate 2 is transparent for light of said wavelength. The temporary carrier substrate can for example be a glass substrate. In the illustrated non-limiting embodiment, the light-sensitive adhesive layer 4 is configured to undergo a reduction of the adhesive force when illuminated by UV (Ultra Violet) light. Adhesives of this type are known in the art as applied for example in conventional UV dicing tapes. Organic UV release layers which are ablated upon exposure can be used as well.

In the example, the LEDs 1 are dies with a square in-plane footprint having a side of about 200 micrometres. The invention is however not limited to these dimensions. The thickness of the transparent carrier 2 in the example is about 600 micrometres. The image in Figure 1 shows only a small portion of the full surface area of the temporary carrier substrate 2 which may for example be a glass wafer of about 20 or 30 cm in diameter.

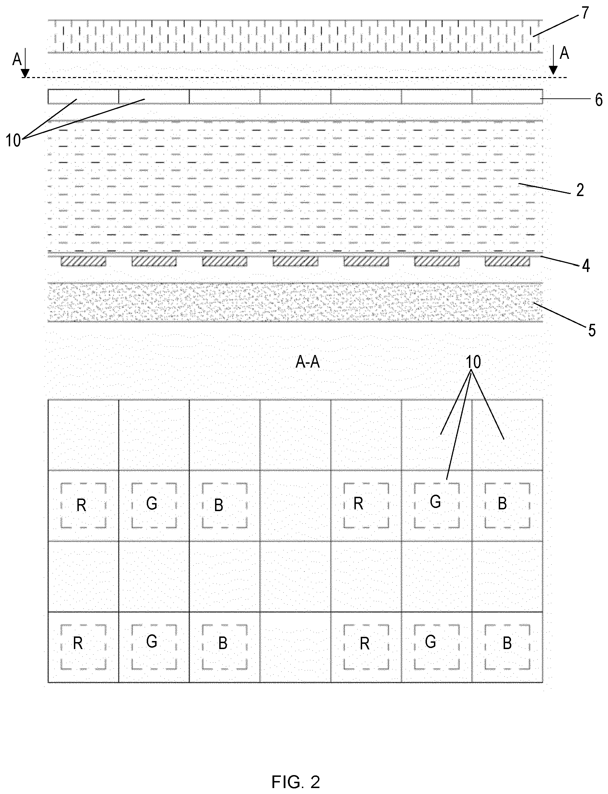

With reference to Figure 2, the temporary carrier substrate 2 is positioned opposite a receiving substrate 5, with the red LEDs 1 facing the receiving substrate, which may be a display substrate of a LED screen onto which the LEDs 1 are to be permanently bonded. The squares marked R, G and B indicate the desired receiving sites of red, green and blue LEDs on the receiving substrate 5. The distance between the LEDs 1 on the temporary carrier substrate 2 and the receiving sites may be in accordance with applicable distances used in known light-induced transfer techniques.

The aim is to transfer individual red, green and blue LEDs from respective temporary carrier substrates to the receiving substrate 5. According to the invention, this is achieved for each of the red, green and blue LEDs, by illuminating selected LEDs through the back side of the temporary carrier substrate 2, while non-selected LEDs remain attached to the temporary carrier. The selection is realized by placing a programmable screen 6 between the back side of the temporary carrier substrate 2 and the light source 7. In the illustrated case, this is a broadband UV light source, schematically represented as a light-emitting layer 7 but which may be implemented in any suitable way known in the art, for example by a mercury lamp or an array of UV LEDs. The screen 6 may be an LCD (Liquid Crystal Display) screen that is programmable so as to be transparent to UV light in selected areas while essentially blocking UV light in other areas. The way in which such programming can be realized is known as such. The screen 6 may overlap the full surface area of the temporary carrier substrate 2, but the screen 6 could also overlap a portion of said temporary carrier substrate 2.

In the plane view shown in Figure 2, a grid of square areas 10 is drawn . These areas represent the areas of the LCD screen 6 which can be programmed to be essentially transparent or essentially non-transparent to light, UV light in the exemplary case, but the invention is not limited to said particular light wavelength. The term 'essentially' is meant to include marginal degrees of transparency or non-transparency regarded as equivalent to 100% transparent or non-transparent in terms of the effect of the transmitted or blocked light on the adhesive layer 4. Throughout this description, the terms 'transparent' and 'non-transparent' are to be understood as 'essentially transparent' and 'essentially non-transparent' in the above-defined sense. According to embodiments, described further in this text, the transparency of selected areas of the screen 6 may be set at an intermediate level between non-transparency and full transparency.

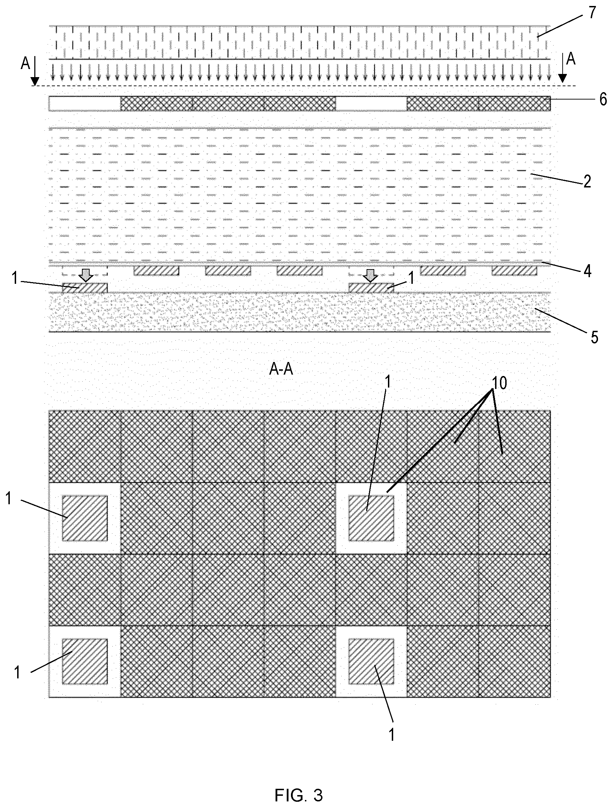

In the exemplary embodiment related to transferring R,G and B LEDs, a first transfer step is performed wherein the screen 6 is programmed so that the square areas 10 are aligned to respective red LEDs 1 on the temporary carrier 2 and so that selected square areas 10 are set to transparent and others to non-transparent. The programming of the screen 6 for the transfer of red LEDs 1 is illustrated in the plane view shown in Figure 3. The square areas 10 are preferably concentrically aligned to the LEDs 1 as shown in the drawing but a slight deviation therefrom is admissible. What counts is that the totality of a LED 1 can be illuminated when a corresponding square area 10 of the LCD screen 6 is set to be transparent.

In the first transfer step, a plurality of red LEDs 1 is transferred to respective 'R' receiving sites, as illustrated in Figure 3. In the wording of the appended claims, the transferred red LEDs 1 form a subgroup of the totality of red LEDs attached to the temporary carrier 2.

The receiving substrate 5 is positioned relative to the carrier 2 so that a red LED 1 on the temporary carrier 2 is aligned to every receiving site marked 'R' on the receiving substrate. The LCD screen 6 is programmed so that only the square areas 10 aligned to the selected LEDs are transparent to the UV light, while all the remaining square areas 10 are non-transparent, i.e. essentially no UV light passes through these areas.

The illumination through the programmed screen 6 therefore results in the release of the selected red LEDs 1 and the transfer of said selected LEDs to the receiving substrate 5, while the remaining LEDs 1 remain attached to the temporary carrier substrate 2.

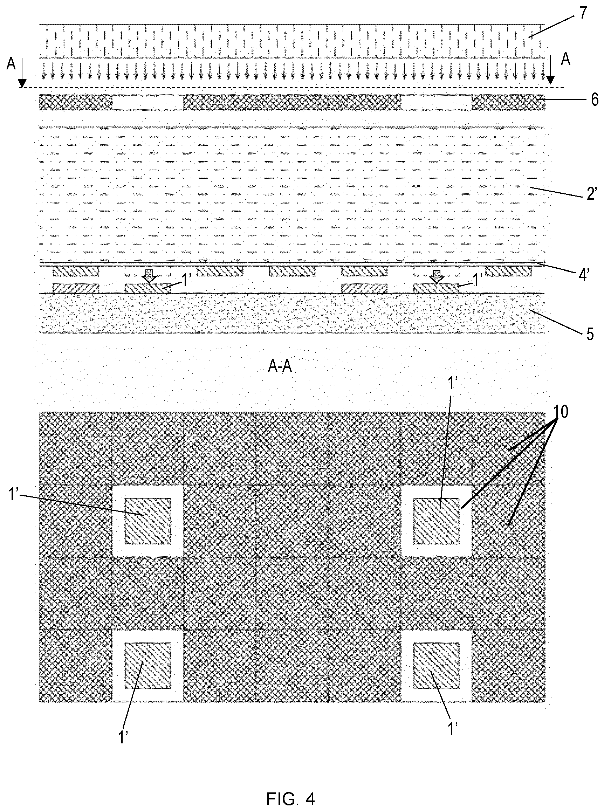

In a second transfer step illustrated in Figure 4, a temporary carrier substrate 2' comprising green LEDs 1' attached by a light-sensitive adhesive layer 4' is positioned facing the receiving substrate 5, with green LEDs 1' aligned to the 'G' marked receiving sites of the receiving substrate. The LCD screen 6 is programmed so that only the areas 10 aligned to said green LEDs 1' are transparent, while other areas 10 are non-transparent. As a result, green LEDs 1' are transferred to the respective receiving sites.

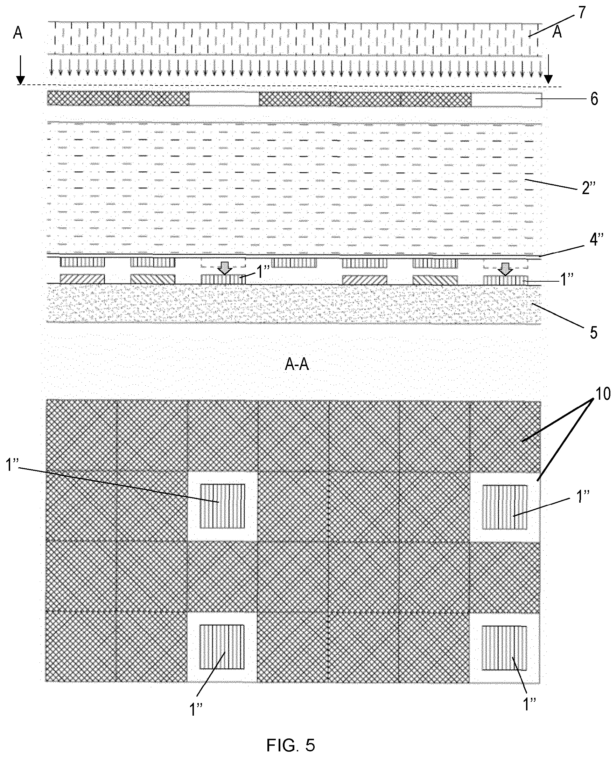

The same process is repeated in the last transfer step illustrated in Figure 5, using a temporary carrier substrate 2" comprising blue LEDs 1" attached by a light-sensitive adhesive layer 4", wherein corresponding areas 10 of the LCD screen 6 are programmed to be transparent, resulting in the transfer of multiple blue LEDs 1" to the respective 'B' receiving sites.

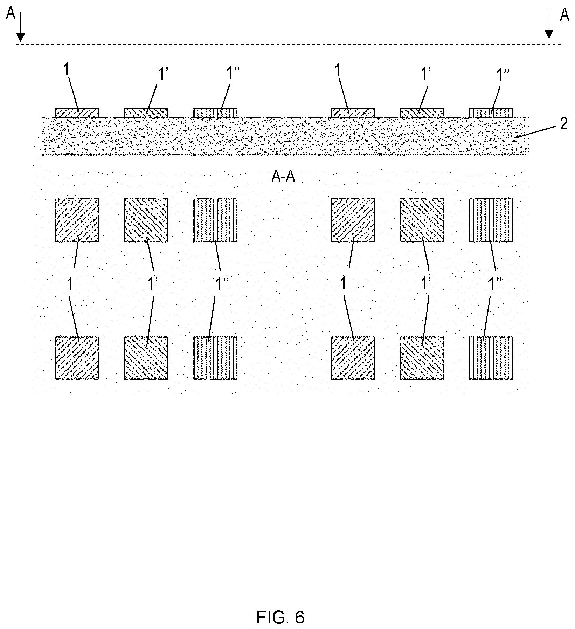

After the three transfer steps, groups of red, green and blue LEDs 1,1',1" are formed on the receiving substrate 5, in accordance with a desired display layout and resolution, as illustrated in Figure 6.

This embodiment of the method thereby enables the mass transfer of large quantities of LEDs of the same colour which are all transferred simultaneously. This represents a significant improvement compared to existing methods wherein LEDs are transferred one by one.

The method is particularly advantageous when applied in combination with a light source configured to illuminate the totality or a large portion of the temporary carrier, such as the broadband UV source 7 illustrated in the above-described example, because such light sources are relatively easy to implement compared to a laser installation. Nevertheless, the invention can be used in combination with a laser as well, for example a UV excimer laser tuned to produce a laser beam of a particular UV wavelength. Using the same configuration as shown in the drawings in terms of the positions of the receiving substrate 5, the temporary carriers 2,2',2" and the programmable screen 6, a focused laser beam can be scanned along a trajectory that includes the transparent areas 10 of the LCD screen 6, to thereby transfer the LEDs aligned to said transparent areas. The advantage compared to traditional laser-induced transfer methods is that the laser can be scanned while remaining active. A UV laser beam can also be shaped by a suitable optics configuration so that the laser beam impinges on a larger surface area of the screen 6 and of the temporary substrate compared to a focused laser beam. The shaped beam is then able to impinge on multiple areas 10 of the screen, so that a subgroup of dies can be released in the same way as described above for the broadband UV source.

When used in combination with a light source that illuminates all or a portion of the temporary carrier (e.g. a broadband UV source or a shaped laser beam), an advantageous mode of operation can be implemented according to embodiments of the invention, wherein selected dies are pre-released, i.e. not fully released but wherein the attachment force is reduced without fully releasing the die. This is achieved by setting the transparency of the corresponding area 10 of the screen 6 to a value between full transparency and non-transparency. Depending on the light source used, this can for example be done by colouring the relevant areas 10 of the screen according to a grayscale configured to partially block the incoming light of the light source.

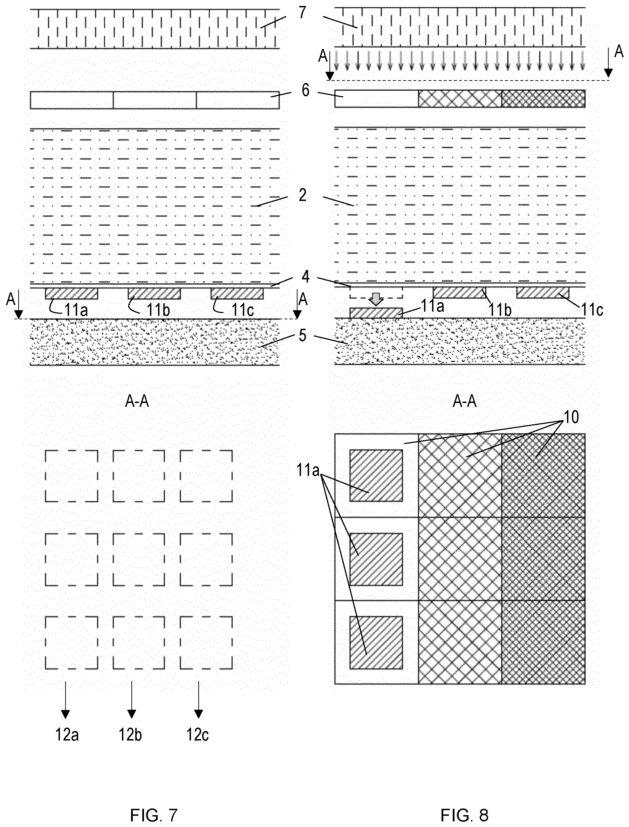

An example is shown in Figures 7 to 10. With reference to Figure 7, dies 11a,11b,11c are to be transferred from the temporary carrier 2 to the receiving substrate 5, wherein a first group of dies 11a are to be transferred to a first group of receiving sites 12a, a second group of dies 11b are to be transferred to a second group of receiving sites 12b and a third group of dies 11c are to be transferred to a third group of receiving sites 12c. The dies in this example are not necessarily LEDs but could be any type of electronic component of dimensions suitable for being transferred by illumination through the back of the carrier 2. As in the previous embodiment, the dies are attached to the temporary carrier 2 by a light-sensitive adhesive layer 4. The pitch (in the horizontal direction of the drawing) between the receiving sites 12a,12b,12c is different from the pitch between the dies 11a,11b,11c on the temporary carrier 2, hence not all dies can be transferred at the same time : the receiving substrate 5 needs to be moved relative to the temporary carrier 2 (or vice versa) in between consecutive steps.

The transfer of the first group of dies 11a is illustrated in Figure 8. The corresponding square areas 10 on the programmable screen 6 are set to fully transparent. The transparency of the screen areas 10 corresponding to the second group of dies 11b is set to an intermediate value between transparent and non-transparent. The areas corresponding to the third group 11c are set to non-transparent. The different transparencies are symbolized by the different hatch patterns applied in the plane view in Figure 8.

The transfer of the first group of dies 11a takes a certain illumination timespan, i.e. the time needed for the adhesive force of the adhesive layer 4 to reduce to the extent that the dies 11a are effectively released. During this timespan, the dies 11b of the second group are pre-released : the adhesive force holding these dies 11b to the temporary carrier 2 is reduced but not to the extent that the dies 11b are fully released.

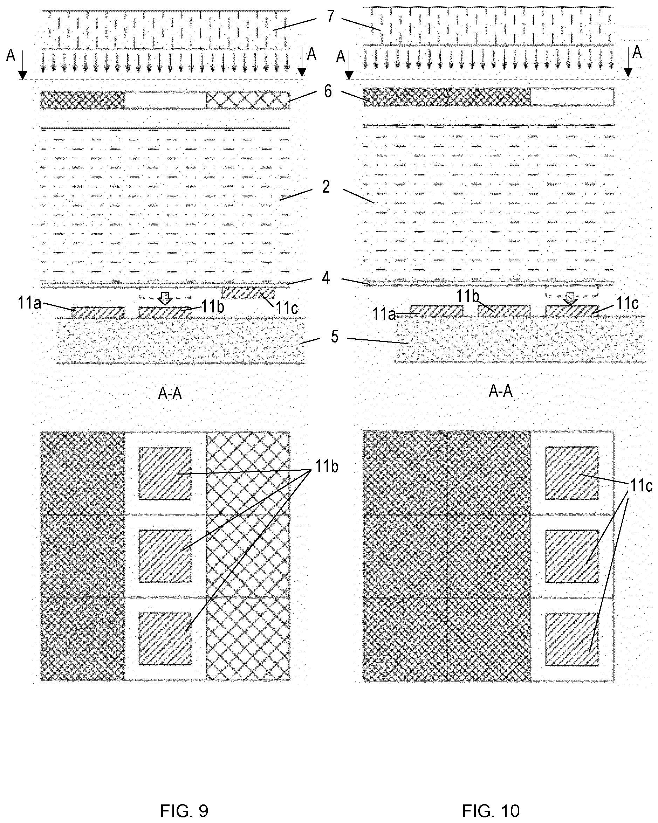

In a second transfer step, the dies 11b of the second group are transferred to the receiving substrate, as illustrated in Figure 9. The receiving substrate 5 is shifted to take into account the change of the pitch between the dies. Due to the reduced adhesion force, the transfer of the second group of dies 11b requires a shorter illumination timespan.

During the second transfer step, the transparency of the screen areas 10 corresponding to the third group of dies 11c is set to an intermediate value higher than the previous intermediate value, taking into account that the required pre-release is to be achieved in a shorter timespan. As the first group of dies 11a are already transferred, the screen areas corresponding to said first group may be set to non-transparent, as shown.

Thereafter, the third transfer step illustrated in Figure 10 transfers the third group of dies 11c in a comparably short timespan as in the second transfer step.

This sequence can be continued a number of times for transferring additional columns of dies, until the transparency can no longer be set to an intermediate value low enough to achieve the desired pre-release. If needed, the sequence can then be started again for a next series of transfer steps. Possibly, the pre-release of dies could be realized in multiple substeps, wherein the transparency of corresponding areas of the screen 6 is progressively increased. These approaches to applying a pre-release of selected dies enable a significant reduction of the overall required time to release and transfer a large number of dies from the same temporary carrier 2.

The pre-release capability can be used in other ways apart from the systematic release sequence described above. For example, when dies on the temporary carrier 2 have been tested, known good dies can be pre-released while defective dies are not released. In this way, the transfer of known-good dies can be speeded up, while the inadvertent transfer of defective dies is avoided.

Another embodiment of a method according to the invention is related to methods for replacing individual dies on a receiving substrate. The screen 6 is then programmed to be non-transparent except in areas aligned to empty receiving sites. The temporary carrier 2 is positioned so that replacement dies are aligned to the empty receiving sites and to the transparent areas of the screen 6, so that multiple replacement dies can be transferred simultaneously to the correct positions. This approach enables again a considerable reduction of the required timespan for replacing multiple dies.

The applicable distance between the light source 7 and the screen 6 or between the screen 6 and the temporary carrier 2 may differ according to the applied light source type, the dimensions of the transferred components, the thickness of the carrier or other parameters. Such finetuning is within the capabilities of the skilled person.

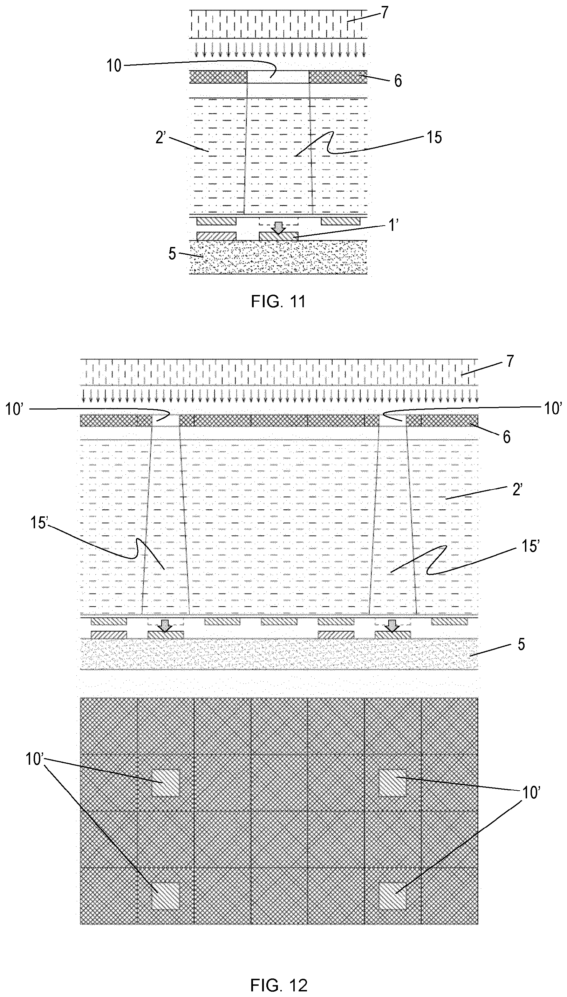

For most types and thicknesses of the temporary carrier substrate 2, light that passes through the transparent (or partially transparent) areas 10 of the screen 6 does not influence the adhesion of dies which are located adjacent the dies aligned to said transparent areas 10 and which are aligned to 'dark' areas 10. Figure 11 is a detail of the section view shown in Figure 4 illustrating the release of green LEDs 1' from the temporary carrier 2. Light is likely to diverge from the footprint of the transparent area 10 of the screen 6 due to diffraction or other optical effects. The cone-shaped area 15 indicates the area into which light having sufficient intensity for releasing the die 1' aligned to the area 10 could propagate. The cone 15 does not overlap the neighbouring dies aligned to 'dark' areas 10, hence these dies are not affected by the transmitted light. However for certain carrier types and/or thicknesses, light may nevertheless propagate to some degree to the neighbouring dies, which could have the unwanted effect of fully or partially releasing dies which are not intended to be released.

To mitigate such unwanted effects, the dimensions of the transparent areas of the screen can be adjusted, as illustrated in Figure 11. The situation shown is analogous to the one shown in Figures 4 and 10, i.e. it illustrates the transfer of green LEDs 1' from a temporary carrier 2' to the receiving substrate 5, but now the thickness of the temporary carrier 2' is higher, so that the diverging cone could reach the neighbouring dies if the surface area of the transparent areas 10 is not adjusted. In the view in Figure 11, this adjustment is applied, i.e. the dimensions of the transparent areas 10' are smaller compared to the configuration of Figure 4, so that the diverging cones 15' do not impinge on the neighbouring dies.

The temporary carrier substrate 2 (or 2',2") can be a glass wafer as described above, but it can also be a tape, such as a dicing tape. In the latter case it may be required to provide a rigid support for the tape, the support itself being also transparent to light produced by the applied light source. Alternatively, the tape could be attached directly to the programmable screen 6. According to further embodiments, it may be suitable to attach the screen 6 directly to the light source 7.

An apparatus in accordance with the invention enables performing the method according to embodiments of the invention, and generally comprises a light source 7, a programmable screen 6, and a holding structure for positioning a receiving substrate 5 and a temporary carrier 2 relative to each other and relative to the programmable screen 6 and the light source 7. The light source can be a light source configured to simultaneously illuminate all or a large portion of a temporary carrier substrate mounted in the apparatus, such as a broadband UV light source, or it may a scannable light source such as a laser. The programmable screen may be in a fixed position relative to the light source or it may be movable in a direction perpendicular to its own surface, to thereby adjust the distance between the screen and the light source. The light source and/or the programmable screen may be fixed parts of the apparatus, or they may be removably mounted in the apparatus, so that the light source and/or the programmable screen can be replaced by another light source or programmable screen. Programming the screen is done on a computer coupled to the screen. The computer may be a part of the apparatus or the apparatus is configured for connection of the screen to an external computer. Method steps according to methods of the invention may be controlled by a control unit that is part of the apparatus or the apparatus may be configured for connection to an external control unit. The control unit may be a computer, possibly the same computer configured for programming the screen. The control unit may operate according to instructions for causing the apparatus to perform method steps according to embodiments of the invention. The invention is related also to a computer program product comprising said instructions, and to a computer-readable medium having stored thereon said computer program product.

## Claims

1. A method for transferring micro-electronic components (1) from a temporary carrier substrate (2) to a receiving substrate (5), wherein the components are attached to said temporary carrier substrate by a light-sensitive adhesive layer (4), wherein the transfer is realized by illuminating the adhesive layer (4) with a light source (7) through the temporary carrier substrate (2), the latter being transparent to light produced by the light source, and wherein :
- the receiving substrate (5) and the temporary carrier substrate (2) are placed relative to each other so that a subgroup of components (1) is facing respective receiving sites (R) for the components of said subgroup on the receiving substrate,
- a programmable screen (6) is positioned between the light source (7) and the temporary carrier substrate (2), said screen being programmable in the sense that the transparency of individual areas (10) of the screen which are aligned to respective individual components (1) on the temporary carrier substrate (2) can be set to a programmed transparency,
- the screen (6) is programmed in such a way that the screen is transparent to light from said light source (7) in areas (10) of the screen aligned to the components (1) of the subgroup, the transparency of said areas being sufficient for releasing the components of the subgroup, while the transparency of areas of the screen aligned to components not belonging to the subgroup is insufficient for releasing said components,
- the light source (7) illuminates the temporary carrier substrate (2) through the programmed screen (6), thereby releasing the components (1) of the subgroup and transferring said components to their respective receiving sites (R), while components not belonging to the subgroup remain attached to the temporary carrier substrate (2).

2. The method according to claim 1, wherein the release of the components of the subgroup (11b) is performed in two or more steps comprising :
- one or more preparatory steps wherein the components (11b) of the subgroup are illuminated through the screen (6) and wherein the screen is programmed in such a way that the screen is intermediately transparent to light from said light source (7) in said individual areas (10) of the screen aligned to the components (11b) of the subgroup, and wherein the intermediate transparency of said individual areas (10) of the screen is sufficient to reduce the adhesive force of said adhesion layer (4) but not sufficient to fully release the components (11b),
- thereafter, a final step wherein the components (11b) of the subgroup are illuminated through the screen (6) and wherein the screen is programmed in such a way that the screen is transparent to light from said light source (7) in said individual areas (10) of the screen aligned to the components (11b) of the subgroup, the transparency of said areas (10) being sufficient for releasing the components of the subgroup in a shorter timespan compared to a timespan required for releasing the components (11b) without applying the one or more preparatory steps.

3. The method according to claim 2, wherein simultaneously with one or more of said preparatory steps, components (11a) of other subgroups are fully released by the illumination of the light source (7).

4. The method according to any one of the preceding claims, wherein said method is applied for transferring red, green and blue LEDs (1,1',1") from respective temporary carrier substrates (2,2',2") onto a receiving substrate (5) according to a given layout and pitch, the method comprising the steps of :
- transferring selected red LEDs (1) to respective receiving sites (R),
- transferring selected green LEDs (1') to respective receiving sites (G),
- transferring selected blue LEDs (1") to respective receiving sites (B),

5. The method according to any one of claims 1 to 3, wherein the components of the subgroup are replacement dies transferred to respective replacement sites on the receiving substrate (5).

6. The method according to any one of the preceding claims, wherein the programmable screen (6) is an LCD (Liquid Crystal Display) screen.

7. The method according to any one of the preceding claims, wherein the light source (7) is configured to illuminate simultaneously all the components (1) of said subgroup.

8. The method according to claim 7, wherein the light source (7) is a broadband UV (Ultra Violet) light source.

9. The method according to any one of claims 1 to 6, wherein the light source is a laser source configured to produce a laser beam, and wherein the laser beam is scanned along a trajectory that includes the areas (10) of the screen (6) aligned to the components (1) of the subgroup.

10. The method according to any one of the preceding claims, wherein the dimensions of said areas (10) of the screen aligned to the components of the subgroup are adjusted to take into account a divergence of light inside the temporary carrier (2), and to thereby avoid the release of components not belonging to the subgroup and aligned to neighbouring areas of the screen (6).

11. An apparatus for performing a method according to any one of the preceding claims, the apparatus comprising a light source (7), a programmable screen (6), and a holding structure for positioning a receiving substrate (5) and a temporary carrier substrate (2) relative to each other and relative to the programmable screen (6) and the light source (7).

12. The apparatus according to claim 11, comprising or configured to be coupled to a computer configured for programming the programmable screen (6).

13. The apparatus according to claim 11 or 12, comprising or configured to be coupled to a control unit configured to operate according to instructions for causing the apparatus to perform method steps of said method.

14. A computer program product comprising instructions for causing the apparatus according to claim 13 to perform method steps of the method according to any one of claims 1 to 10.

15. A computer-readable medium having stored thereon a computer program product according to claim 14.
